# EUROPEAN PATENT SPECIFICATION

(11) **EP 0 559 243 B1**
(45) Date of publication and mention of the grant of the patent: **02.04.1997**
(21) Application number: 93200183.7
(22) Date of filing: 26.01.1993
(51) Int. Cl.: H03K 5/24, G01R 19/00, G01R 19/165, H03F 1/52

(54) **Comparator circuit comprising input signal attenuator**
Komparatorschaltung mit Eingangssignaldämpfungsglied
Circuit comparateur muni d'un atténuateur de signal d'entrée

(30) Priority: 03.02.1992 EP 92200297
(43) Date of publication of application: 08.09.1993
(73) Proprietor: Philips Electronics N.V., 5621 BA Eindhoven (NL)
(72) Inventor: Schoofs, Franciscus Adrianus Cornelis Maria, NL-5656 AA Eindhoven (NL)
(74) Representative: Schoonheijm, Harry Barend

(56) References cited:
- EP-A- 0 318 110
- WO-A-90/12324
- US-A- 4 057 844
- US-A- 4 086 642
- US-A- 4 346 347

## Description

The invention relates to a comparator circuit comprising a comparator which includes a first and a second supply terminal for connecting a supply voltage to these terminals, a first input terminal for connecting a reference voltage, and a second input terminal connected *via* an attenuation means to a signal terminal for connecting an input voltage. A comparator circuit of this type is of general knowledge (see, for example, US-A-4 346 347) and is used for a great variety of applications. The input voltage is compared with the reference voltage and the comparator signals when the input voltage exceeds the reference voltage. The reference voltage has a value which lies in the supply voltage range of the comparator. For measuring input voltages which are large relative to the comparator reference and supply voltages, an attenuator is generally used to bring the input voltage within the range determined by the supply voltage. *In lieu of* the attenuation means, a resistance divider may be used which has a large series resistance between the signal terminal and the second input terminal and, as required, a further resistance between the second input terminal and the second supply terminal. In that case there is a linear relationship between the input voltage and the attenuated voltage on the second input terminal of the comparator. In many cases the linear relationship is not even required. In that case the attenuation means may, in known fashion, consist of a series resistance between the signal terminal and the second input terminal and clamping means between the second input terminal and the second supply terminal so as to limit the signal. A disadvantage of these known attenuators is the series resistance. This has to be a large value which is an objection especially in integrated circuits. Another known non-linear attenuation may be obtained by means of a diode whose cathode is connected to the signal terminal and whose anode is connected to the second input terminal of the comparator and also, by means of a series resistance, to the reference voltage source. The diode is blocked to high signal voltages and rendered conductive in the case of signal voltages smaller than or equal to the reference voltage. A disadvantage of this known attenuator is the voltage drop across the diode which is undesired with relatively small input voltages.

It is an object of the invention to provide a comparator circuit comprising an attenuation means which permits a large input voltage range, integrates well and presents a substantially linear attenuation for small input signals. Thereto, according to the invention the comparator circuit mentioned in the opening paragraph is characterized, in that the attenuation means comprises a resistor, a bias voltage terminal for connecting a bias voltage, and a MOS transistor with a gate, backgate, source and drain, the drain being connected to the signal terminal, the source and the backgate being connected to the second input terminal, the gate being connected to the bias voltage terminal and the resistor being inserted between the gate and the source.

With the aid of this attenuation means there is achieved that in the case of high input voltages the MOS transistor operates in its saturation range and forms a high impedance between the signal terminal and the second input terminal. In the case of low input voltages the MOS transistor operates in the linear range and forms a low impedance (RDS-on) between these terminals.

Integrated circuits are usually formed in a monolithic semiconductor substrate. The voltages applied to the circuit must not fall below the substrate voltage, at any rate for a P-substrate. For an N-substrate the reverse is the case and voltages must not exceed the substrate voltage. For still admitting input voltages (for the P-substrate) which are lower than the substrate voltage, a further embodiment of the comparator circuit according to the invention is characterized, in that the MOS transistor is a DMOS transistor, inserted in an island-shaped area of a first conductivity type on a substrate of a second conductivity type which is the opposite of the first conductivity type, in which the island-shaped area is surrounded by a first tub of the second conductivity type isolated from the substrate by a second tub of the first conductivity type surrounding the first tub, and by a buried layer of the first conductivity type stretching out between the first tub and the substrate, the first and the second tubs having each a terminal which is connected to the source and gate respectively. If the drain voltage falls below the substrate voltage, the junction formed by the first and second tubs will be rendered non-conductive. In the case of a high drain voltage, the source voltage is never higher than the bias voltage of the bias voltage source and said junction will likewise be rendered non-conductive. The use of DMOS transistors allows a very high input voltage and renders the comparator circuit pre-eminently suitable for use in circuits directly fed from a rectified mains voltage carrying several hundred volts. The input voltage, for example, when the circuit is switched on, may then temporarily be much higher than permitted for the comparator.

These and other aspects of the invention will be described and explained with reference to the appended drawing, in which:
Fig. 1 shows a comparator circuit according to the invention,
Fig. 2 shows a lateral DMOS transistor to be used in a comparator circuit according to the invention, and
Fig. 3 shows an alternative lateral DMOS transistor to be used in a comparator circuit according to the invention.

In the drawing Figures elements having like functions or connotations have like reference characters.

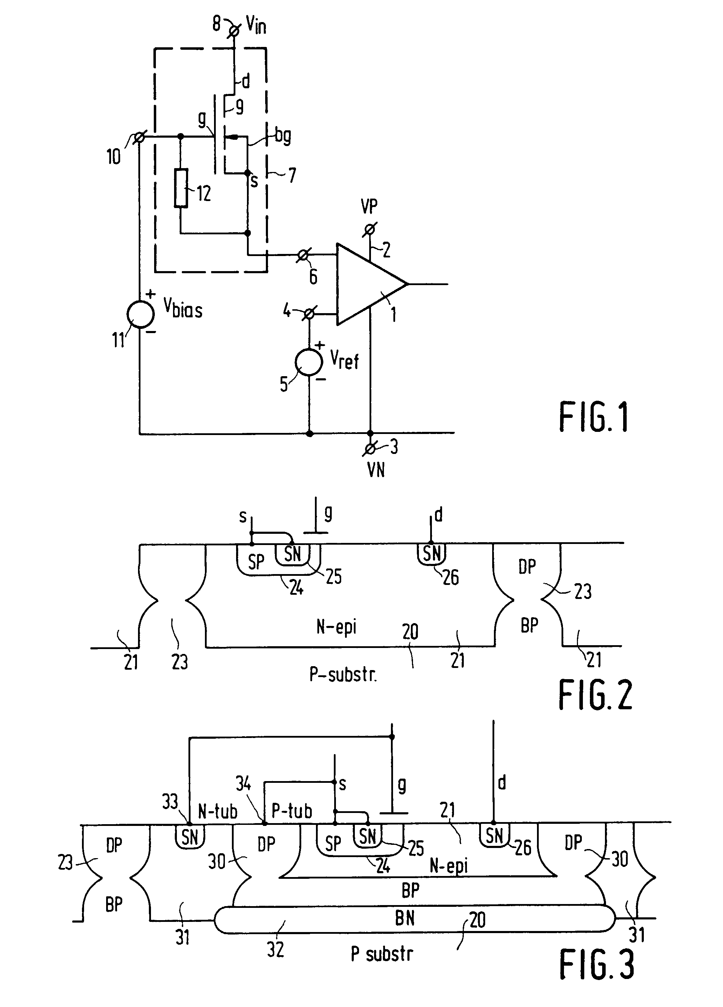

Fig. 1 shows an integrated version of a comparator circuit according to the invention. The circuit comprises a comparator 1 which includes a first supply terminal 2 to which a positive supply voltage VP is connected and includes a second supply terminal 3 to which a negative supply voltage VN is connected. The second supply terminal 3 is also connected to the P-substrate of the integrated comparator circuit. The comparator 1 comprises a first input terminal 4 to which a reference voltage source 5 is connected which supplies a reference voltage Vref relative to the second supply terminal 3. The comparator 1 further includes a second input terminal 6 connected *via* an attenuation means 7 to a signal terminal 8 to which an input voltage Vin is connected. The attenuation means comprises a MOS transistor 9 with a drain d connected to the signal terminal 8, a source s and a backgate bg which are interconnected and also connected to the second input terminal 6, a gate g connected to the bias voltage terminal 10 to which a bias voltage source 11 is connected which source supplies a bias voltage Vbias relative to the second supply terminal 3, and also a resistor 12 inserted between the gate g and the source s of the MOS transistor 9.

The positive supply voltage VP and the bias voltage Vbias are, for example, 7 volts. The threshold voltage of the MOS transistor 9 is, for example, 2.5 volts. The resistor 12 has a value of, for example, 1 megohm. The source s is capable of following the voltage on the drain d *via* the backgate drain junction once the drain voltage has fallen below Vbias minus 0.7 volt (6.3 V). If the drain voltage falls below Vbias minus the threshold voltage (7 V - 2.5 V = 4.5 V), the channel of the MOS transistor 9 is rendered conductive and the backgate drain junction is shunted by the relatively low impedance Rds-on of the channel. In that case the source s rather accurately follows the voltage on the drain d. For drain voltages exceeding the bias voltage Vbias, the MOS transistor 9 is in saturation, whilst the source voltage is substantially independent of the drain voltage and maintains a constant value of approximately Vbias. The drain voltage and thus also the input voltage Vin may then increase in so far the MOS transistor 9 is capable of withstanding this, without the source voltage and thus also the voltage on the second input terminal 6 of the comparator 1 increasing. In this manner there is achieved that on the second input terminal 6 of the comparator 1 no voltages become available which exceed the bias voltage Vbias. By selecting a value for Vbias which is safe for the comparator 1, for example, VP, but lower or higher is also permitted, there is avoided that the comparator 1 fails if the input voltage Vin on the signal terminal 8, temporarily or not, or purposely, has a high value. The breakdown voltage of the MOS transistor 9 eventually determines the maximum permitted value for the input voltage Vin. For a lateral DMOS transistor (Double Diffused Metal Oxide Semiconductor) the breakdown voltage may be several hundred volts.

Fig. 2 shows the structure of a lateral DMOS transistor on a P-substrate 20 which has an N-epitaxial layer 21 and isolation zones 23 of P-material. In the layer 21 there is the body (backgate) 24 of P-material with included therein the source 25 of N-material. Body 24 as well as source 25 are interconnected *via* source contact s. At some distance from the body 24 there is the drain 26 which, just like the source 25, is made of N-material and comprises a drain contact d. The gate g is disposed over the body 24 and source 25 and isolated therefrom.

The junction between drain 26 and substrate 20 prevents applying to signal terminal 8 input voltages that come below the substrate voltage (0 volts). By surrounding the lateral DMOS transistor with a P-tub 30 isolated from the P-substrate 20 by an N-tub 31 and an N-type buried layer 32, as is demonstrated in Fig. 3, also negative input voltages relative to the substrate can be admitted. For this purpose, a contact 33 of the N-tub 31 is connected to gate g and a contact 34 of the p-tub is connected to the source s of the lateral DMOS transistor. If the drain d is supplied with a voltage of, for example, -10 volts relative to the P-substrate 20, the voltage of the P-tub 30 is also about -10 volts and the junction between the P-tub 30 and the buried N-layer 32 is rendered non-conductive with a voltage of 17 volts. If the drain voltage is high, for example, 200 volts, the source voltage does not exceed Vbias (7 volts) and the junction between the P-tub 30 and the buried N-layer 32 is also rendered non-conductive.

The conductivity types of the materials shown may also be selected to be of the opposite type. In that case the polarity of all the voltages is to be reversed. The comparator circuit according to Fig. 1 may naturally also comprise discrete components. For example, a normal discrete vertical DMOS transistor may then be substituted for MOS transistor 9.

## Claims

1. Comparator circuit comprising a comparator (1) which includes a first (2) and a second (3) supply terminal for connecting a supply voltage (VP, VN) to these terminals, a first input terminal (4) for connecting a reference voltage (Vref), and a second input terminal (6) connected *via* an attenuation means (7) to a signal terminal (8) for connecting an input voltage (Vin), characterized in that the attenuation means (7) comprises a resistor (12), a bias voltage terminal (10) for connecting a bias voltage (Vbias), and a MOS transistor (9) with a gate (g), backgate (bg), source (s) and drain (d), the drain (d) being connected to the signal terminal (8), the source (s) and the backgate (bg) being connected to the second input terminal (6), the gate (g) being connected to the bias voltage terminal (10) and the resistor (12) being inserted between the gate (g) and the source (s).

2. Comparator circuit as claimed in Claim 1, characterized in that the MOS transistor (9) is a DMOS transistor, inserted in an island-shaped area (21) of a first conductivity type (N) on a substrate (20) of a second conductivity type (P) which is the opposite of the first conductivity type, in which the island-shaped area (21) is surrounded by a first tub (30) of the second conductivity type (P) isolated from the substrate (20) by a second tub (31) of the first conductivity type (N) surrounding the first tub (30), and by a buried layer (32) of the first conductivity type (N) stretching out between the first tub (30) and the substrate (20), the first (30) and the second tubs (31) having each a terminal (34, 33) which is connected to the source (s) and gate (g) respectively.

## Patentansprüche

1. Komparatorschaltung mit einem Komparator (1), der eine erste (2) und eine zweite (3) Versorgungsklemme zum Anschließen einer Versorgungsspannung (VP, VN) an diese Klemmen hat, eine erste Eingangsklemme (4) zum Anschließen einer Bezugsspannung (Vref), und eine über ein Dämpfungsmittel (7) mit einer Signalklemme (8) verbundene zweite Eingangsklemme (6) zum Anschließen einer Eingangsspannung (Vin), dadurch gekennzeichnet, daß das Dämpfungsmittel (7) einen Widerstand (12), eine Vorspannungsklemme (10) zum Anschließen einer Vorspannung (Vbias) und einen MOS-Transistor (9) mit einem Gate (g), Backgate (bg), Source (s) und Drain (d) umfaßt, wobei das Drain (d) mit der Signalklemme (8) verbunden ist, die Source (s) und das Backgate (bg) mit der zweiten Eingangsklemme (6) verbunden sind, das Gate (g) mit der Vorspannungsklemme (10) verbunden ist und der Widerstand (12) zwischen dem Gate (g) und der Source (s) eingefügt ist.

2. Komparatorschaltung nach Anspruch 1, dadurch gekennzeichnet, daß der MOS-Transistor (9) ein DMOS-Transistor ist, der in ein inselförmiges Gebiet (21) eines ersten Leitungstyps (N) auf einem Substrat (20) eines dem ersten Leitungstyp entgegengesetzten zweiten Leitungstyps (P) eingebracht worden ist, wobei das inselförmige Gebiet (21) von einer ersten Wanne (30) des zweiten Leitungstyp (P) umgeben ist, die vom Substrat (20) durch eine die erste Wanne (30) umgebende zweite Wanne (31) des ersten Leitungstyps (N) und durch eine sich zwischen der ersten Wanne (30) und dem Substrat (20) erstreckende vergrabene Schicht (32) des ersten Leitungstyps (N) isoliert ist, wobei die erste (30) und die zweite Wanne (31) je eine Klemme (34, 33) haben, die mit der Source (s) bzw. dem Gate (g) verbunden ist.

## Revendications

1. Circuit comparateur comportant un comparateur (1) qui renferme des première (2) et deuxième bornes d'alimentation (3) pour la connexion d'une tension d'alimentation (VP, VN) à ces bornes, une première borne d'entrée (4) pour la connexion d'une tension de référence (Vref) et une deuxième borne d'entrée (6) reliée par l'intermédiaire de moyens d'affaiblissement (7) à une borne de signal (8) pour la connexion d'une tension d'entrée (Vin), caractérisé en ce que les moyens d'affaiblissement (7) comportent une résistance (12), une borne de tension de polarisation (10) pour la connexion d'une tension de polarisation (Vbias) et un transistor dit MOS (9) présentant une porte (g), une arrière-porte (bg), une source (s) et un drain (d), le drain (d) étant relié à la borne de signal (8), la source (s) et l'arrière-porte (bg) étant reliées à la deuxième borne d'entrée (6), la porte (g) étant reliée à la borne de tension de polarisation (10) et la résistance (12) étant disposée entre la porte (g) et la source (s).

2. Circuit comparateur selon la revendication 1, caractérisé en ce que le transistor dit MOS (9) est un transistor dit DMOS étant disposé dans une zone en forme d'île (21) d'un premier type de conductivité (N) sur un substrat (20) d'un deuxième type de conductivité (P) qui est l'opposé du premier type de conductivité dans lequel la zone en forme d'île (21) est entourée d'un premier puits (30) du deuxième type de conductivité (P) étant isolé du substrat (20) par un deuxième puits (31) du premier type de conductivité (N) entourant le premier puits (30) et par une couche enterrée (32) du premier type de conductivité N s'étendant entre le premier puits (30) et le substrat (20), les premier (30) et deuxième puits (31) présentant chacun une borne (34, 33) qui est reliée à la source (s) respectivement à la porte (g).
